# EUROPEAN PATENT APPLICATION

(11) **EP 0 782 014 A2**
(43) Date of publication of application: **02.07.1997**
(21) Application number: 96120898.0
(22) Date of filing: 27.12.1996
(51) Int. Cl.: G01V 15/00, G01R 33/02

(54) **Magnetic element**

(30) Priority: 27.12.1995 JP 340291/95
(71) Applicant: UNITIKA LTD., Amagasaki-shi Hyogo (JP)
(72) Inventor: Furukawa, Shinji, Kyoto-shi, Kyoto (JP); Yano, Nobuyoshi, Uji-shi, Kyoto (JP); Hirano, Toshiyuki, Uji-shi, Kyoto (JP)
(74) Representative: Hansen, Bernd, Dr. Dipl.-Chem.

(57) **Abstract**

A magnetic element comprising an operation portion having a length L which undergoes a steep change in magnetization with a change in external magnetic field and at least one pair of control portions having a coercive force that is higher than that of the operation portion. The control portions are arranged so that a magnetic pole of each of the control portions is generated within a range of not more thin 0.3L from the end of the operation portion, and the control portions are not present within a range of up to 0.2L from the center of the operation portion. The magnetic element of the present invention has a small size and good magnetic characteristics. Furthermore, it has a simple structure that is easily prepared. Moreover, the magnetic characteristics of the magnetic element of the present invention are highly reproducible.

## Description

### BACKGROUND OF THE INVENTION

### 1. Field of the Invention

The present invention relates to a magnetic element utilizing a phenomenon that magnetization suddenly changes with the change in the external magnetic field.

### 2. Description of the Related Art

Heretofore, various devices which utilize the magnetization behavior of a magnetic material have been widely used. Aside from devices which provide a continuous magnetization response to a change in external magnetic field, such as electromagnetic induction type magnetic head, a magnetic material which shows a sudden change in magnetization to provide a discontinuous response when the intensity of magnetic field exceeds a predetermined value has been widely used in recent years. If a pickup coil is disposed in the vicinity of such a magnetic material, a steep voltage pulse is induced in the coil when the magnetic material exhibits a discontinuous magnetization reversal. The use of such a magnetic material as a sensor makes it possible to provide an apparatus having a simple configuration. Thus, this kind of magnetic material is used to measure magnetic fields relating to, for example, earth field, rotational speed flow rate, etc.

Furthermore, in recent years, the use of electronic article surveillance systems or identification systems for preventing the theft of article or for rapidly processing material flow have expanded. An identification marker for use in conjunction with such systems is a magnetic material which shows discontinuous magnetization in addition to an oscillating circuit, an LC resonance circuit, a magnetostrictive oscillating material and a high permeability material. For example, U.S. Patent Nos. 4,660,025, 4,686,516 and 4,797,658 disclose a system using a marker made of an Fe-based amorphous fine metallic wire. The foregoing fine metallic wire shows a very stable longitudinal magnetization and thus exhibits a sudden 180° magnetization reversal when the magnitude of the magnetic field reaches a predetermined value. When an alternating magnetic field generated in the surveillance system reaches the critical value as an inquiry signal, the amorphous fine metallic wire exhibits a discontinuous magnetization reversal to induce a steep voltage pulse in the detection coil. The waveform of this voltage is then frequency-analyzed. The intensity or ratio of higher harmonics is then determined to identify the marker or to sound an alarm if needed. This system is advantageous in that it less expensive than other systems and provides high identification properties. Known magnetic materials which provide a discontinuous response include many materials besides the foregoing amorphous fine metallic wire. With regard to a amorphous metal thin film formed on a plastic substrate such as synthetic resin film, for example, U.S. Patent 5,181,020 discloses that a thin film, having a strong uniaxial magnetic anisotropy shows a discontinuous magnetization reversal and has an excellent rectangular hysteresis similar to an amorphous fine metallic wire.

JP-A-6-044771 describes that a material obtained by drawing and annealing a wire material made of FeNi, CoFeV or the like does not exhibit a rectangular hysteresis but does show a discontinuous magnetization jump.

Furthermore, U.S. Patent, 4,980,670 discloses a material obtained by annealing a slender amorphous metal ribbon in a magnetic field. Annealed ribbon has a passive 180° magnetic wall formed therein. Thus, the nucleation and growth of reverse domains are controlled. When the intensity of the external magnetic field is increased, the material shows a discontinuous magnetization reversal at a critical field. The magnitude of the discontinuous magnetization reversal reaches about one-half of the saturation magnetization.

Furthermore, U.S. Patent 5,313,192 refers to such a material having an improved amorphous metal ribbon. When the annealing temperature is somewhat raised up, the surface of the ribbon is crystallized to exhibit a high coercive force. Such a partial crystallized ribbon exhibits a behavior quite different from materials which do not have a crystalline phase. The magnetization process of the ribbon is reversibly controlled by the magnetization state of the surface crystalline phase. When the crystalline phase is magnetized in advance, the material shows a discontinuous magnetization reversal. This phenomenon disappears upon demagnetization and therefore enables non-destructive activation and deactivation of an anti-theft marker which is advantageous for repeated use. This patent further discloses that a hard magnetic thin film formed as a high coercive layer on the surface of the material by evaporation or the like can exert similar effects.

The foregoing drawn wire material reportedly shows a similar phenomenon. In particular, Canadian Patent 2,088,207 and EP Patent Disclosure No. 557,689 describe a discontinuous magnetization response by a fine clad wire obtained by drawing a hard magnetic material which exhibits phase transition upon annealing in combination with a soft magnetic material. Such a fine clad wire shown a discontinuous magnetization reversal which is induced in the core soft magnetic layer when the hard magnetic shell layer is magnetized in advance.

However, the amorphous metal ribbon or fine clad wire having a crystallized surface is disadvantageous in that it in greatly affected by the amount or magnetic characteristics of the soft magnetic layer and hard magnetic layer. Thus, discontinuous magnetization reversal can be provided only in an extremely narrow region in the structure. The resulting magnetic characteristics are instable.

As the apparatus has become highly advanced, the required sensor size has progressively decreased. However, a magnetic characteristic of a magnetic material is closely related to its shape, and it is hard to produce a compact marker. For example, in the system mentioned above, an Fe-based amorphous thin wire of length of about 90 mm and diameter of about 130 µm is used. Generally, when a magnetic material is magnetized, magnetic poles appear at two ends thereof, and a magnetic flux of an opposite direction to the applied field is generated from the magnetic poles, and it affects the material itself. This is called usually as demagnetizing field, and it operates as a resistance against the magnetization of the material along the applied field. The demagnetizing field increases with increase in a ratio of cross sectional area to length. Then, in order to reduce the effect of the demagnetizing field, a thinner wire may be used. However, as the diameter of the wire decreases, the total volume thereof decreases and a sufficient amount of magnetic flux can not be obtained, and a voltage induced in the detection coil decreases. Then the marker can not be so narrow.

The above also applies to an magnetic thin film. In order to miniaturize the marker or sensor, the length of the thin film must be decreased. However, this makes it necessary to increase the width or thickness of the film to obtain the requisite magnetization response. The resulting demagnetizing field distorts the hysteresis loop. This renders the thin film incapable of showing a steep magnetization change. That is, the thin film exhibits deteriorated magnetic characteristics.

As discussed above, the needed to miniaturize the sensor or marker conflicts with need for providing a sufficient magnetic flux change for accurate detection by a monitoring device.

### SUMMARY OF THE INVENTION

It is therefore an object of the present invention is to provide a compact magnetic element having excellent magnetic characteristics.

The inventors conducted extensive studies to solve the above-described problems. As a result, the present inventors discovered that a magnetic element comprising an operation portion which undergoes a steep change of magnetization with a change in an external magnetic field and at least a pair of control portions disposed in a specific position has a small size and excellent magnetic characteristics. The present invention has been achieved based on the above findings.

More particularly, the present invention provides a magnetic element comprising an operation portion of length L which undergoes a sudden change in magnetization with a change in an external magnetic field and at least one pair of control portions having a coercive force that is higher than that of said operation portion, wherein said control portions are disposed in such manner that a magnetic pole of each of said control portions is generated within a range of not more than 0.3L from an and of said operation portion and said control portions are not present within a range of up to 0.2L from the center of said operation portion.

The magnetic element of the present invention has a small size and good magnetic characteristics. Furthermore, it has a simple structure that can be easily prepared. The magnetic characteristic of the magnetic element of the present invention are also highly reproducible.

### BRIEF DESCRIPTION OF THE DRAWING

In the accompanying drawings:
Fig. 1 is a schematic diagram illustrating an embodiment of the magnetic element of the present invention having first and second control portions (i.e., one pair of control portions) each disposed in the vicinity of the respective ends of an operation portion;
Fig. 2 is a schematic diagram illustrating another embodiment of the magnetic element of the present invention having first and second control portions (i.e., one pair of control portions) each disposed in the vicinity of the respective ends of an operation portion;
Fig. 3 is a schematic diagram illustrating another embodiment of the magnetic element of the present invention having first and second control portions (i.e., one pair of control portions) each disposed in the vicinity of the respective ends of an operation portion;
Fig. 4 is a schematic diagram illustrating another embodiment of the magnetic element of the present invention having first and second control portions (i.e., one pair of control portions) each disposed in the vicinity of the respective ends of in operation portion;
Fig. 5 is a schematic diagram illustrating an embodiment of the magnetic element of the present invention having two pairs of control portions disposed in the vicinity of each of the respective ends of an operation portion;
Fig. 6 is a schematic diagram illustrating another embodiment of the magnetic element of the present invention having two pairs of control portions disposed in the vicinity of the respective ends of an operation portion;
Fig. 7 is a schematic diagram of the magnetic element prepared in Example 1;
Fig. 8 illustrates the magnetic hysteresis loop of an amorphous fine metallic wire (length: 25 mm) used as an operation portion in Example 1;
Fig. 9 is a magnetic hysteresis loop illustrating the magnetic characteristics of the magnetic element prepared in Example 1 when it is demagnetized in advance;
Fig. 10 is a magnetic hysteresis loop illustrating the magnetic characteristics of the magnetic element prepared in Example 1 when its control portion is magnetized longitudinally with respect to the morphous fine metallic wire;
Fig. 11 is a magnetic hysteresis loop illustrating the magnetic characteristics of the magnetic element of Example 1 when two sheets of semi-hard segments (control portions) are disposed at each end of the operation portion in such manner that they are magnetized in directions opposite to each other;
Fig. 12 is a schematic diagram of the magnetic element prepared in Comparative Example 1;
Fig. 13 is a magnetic hysteresis loop illustrating the magnetic characteristics of the magnetic element prepared in Comparative Example 1 when its control portion is magnetized longitudinally with respect to the amorphous fine metallic wire;
Fig. 14 is a diagram illustrating a print pattern of the water-soluble ink of Example 2;
Fig. 15 is a magnetic hysteresis loop illustrating the magnetic characteristics of the PET film in combination with a thin film prepared in Example 2;
Fig. 16 is a schematic diagram illustrating the magnetic element of the present invention prepared in Example 2;
Fig. 17 is a schematic diagram illustrating the magnetic characteristics of the magnetic element prepared in Example 2 when its control portions are magnetized longitudinally with respect to the thin film;
Fig. 18 is a schematic diagram illustrating the magnetic element prepared in Comparative Example 2;
Fig. 19 is a magnetic hysteresis loop illustrating the magnetic characteristics of the magnetic element prepared in Comparative Example 2 when its control portion is magnetized longitudinally with respect to the thin film;
Fig. 20 is a magnetic hysteresis loop illustrating the magnetic characteristics of the magnetic element prepared in Example 3 when the control portions are magnetized longitudinally with respect to the thin film (operation portion);
Fig. 21 is a diagram illustrating a print pattern of the water-soluble ink of Example 4; and
Fig. 22 is a magnetic hysteresis loop illustrating the magnetic characteristics of the magnetic element prepared in Example 4 when the control portions are magnetized longitudinally with respect to the thin film (operation portion).

### Description of reference numerals

- 1: Operation portion
- 2: Control portion

### DETAILED DESCRIPTION OF THE INVENTION

The present invention is described in greater detail below.

The magnetic element of the present invention comprises an operation portion and at least a pair of control portions. The term "operation portion" as used herein is means a portion which undergoes a steep, discontinuous change in magnetization change in an external magnetic field. The magnetization behavior of this portion is controlled by the magnetization state of the control portion.

The control portion has a coercive force that is higher than that of the operation portion. When the length of the operation portion is L, the control portions are disposed in such manner that magnetic pole is generated within a range of not more than 0.3L from the end of the operation portion. Furthermore, the control portion is not present within a range of not more than 0.2L from the center of the operation portion. Preferably, the control portions are nearly symmetrically in the vicinity of the ends of the operation portion. The operation portion is preferably made of a material in which the coercive force is smaller than that of the operation portion and the squareness (Br/Bs) is in the vicinity of 1. As an alloy composition, a crystalline alloy such as Fe, Co, Ni, FeCo, FeCoCr, FeCoV or FeC is preferable. In addition to this, a crystallized amorphous alloy similar to the operation portion, a thin film which is interposed on an extremely rough surface (including the amorphous alloy and a thin film on an ink corresponds to this) can be used as the operation portion.

In the magnetic element of the present invention, the control portions are magnetized by d.c. magnetic field so that the operation portion is biased with a static magnetic field. The control portion at both ends of the operation portion are magnetized in the same direction. When local magnetic field of the same direction is biased to the vicinity of the ends of the operation portion, the operation portion undergoes a discontinuous magnetization reversal and exhibits a steep magnetization jump by applying alternating magnetic field. If the control portions are magnetized in directions opposite to each other from one end of the operation portion to the other, the magnetization behavior of the operation portion resembles that developed when no control portions are provided or the control portions are demagnetized.

The operation portion of the present invention may comprise used a wire, ribbon or thin film having a small coercive force. The operation portion most desirably comprises an amorphous metal. Examples of alloy composition desirable for the operation portion preferably include FeB, FeP, FeC, FeSiB and FeZr. Compositions obtained by replacing a part or all of the Fe by Co or Ni are also desirable.

The control portion of the present invention may comprise a hard magnetic material in the form of segment, thin film or coating ink. Such a magnetic material having a high coercive force is magnetized by d.c. magnetic field, to thereby apply bias magnetic field having a proper intensity to the operation portion at effective positions. As a result, a discontinuous magnetization reversal is induced in the operation portion. The control portion in the form of a may be adhered to the operation portion at a desired position. Alternatively, a control portion in the form of a thin film may be evaporated onto the operation portion at a desired position. Furthermore, a control portion in the form of coating may be painted magnetic ink to the operation portion at a desired position.

The magnetic element comprises at least one pair, and preferably two or three pairs of control portions.

In the present invention, with regard to the positioning of the control portion, the control portion is disposed in such manner that a magnetic pole of the control portion is generated within a range of not more than 0.3L, (i.e., not more than 30% of the length of the operation portion from the ends of the operation portion from the center of the operation portion) and is not present within a range of not more than 0.2L, (i.e., not more than 20% of the length of the operation portion). In other words, it is desirable to effectively bias the local magnetic field to the vicinity of the ends of the operation portion.

In addition, the size of the operation portion and the control portion in not limited. However, because they are required to be small, the size of the operation portion is in the range of 5 mm to 100 mm, preferably, 10 mm to 40 mm, and that of the control portion is in the range of 1 mm to 20 mm, preferably, 3 mm to 10 mm.

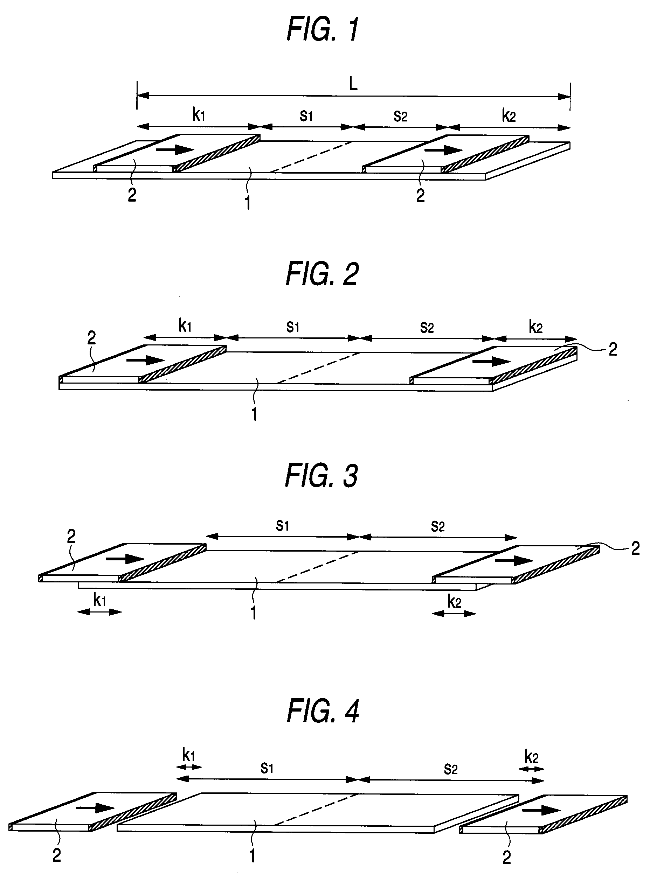

Figs. 1 to 6 each illustrate an example of the positioning of the control portion with respect to the operation portion in the magnetic element of the present invention, but the present invention should not be construed as being limited thereto. Various cases can be considered.

Figs. 1 to 4 each illustrates an embodiment of the magnetic element having first and second control portions disposed in the vicinity of the respective ends of the operation portion. Fig. 1 illustrates the case where each control portion is disposed inside the respective ends of the operation portion. Fig. 2 illustrates the case where the end of each control portion coincides with that of the operation portion. Fig. 3 illustrates the case where each control portion protrudes from the respective ends of the operation portion. Fig. 4 illustrates the case where each control portion is not superposed on the operation portion and is present outside the operation portion. In this case, a supporting member (not shown) is necessary to support the control portions and the operation portion. In the present invention, it is important to the position of the magnetic pole closer to the center of the operation portion among the two magnetic poles generated by the control portions relative to the operation portion. In other words, in any of Figs. 1 to 4, the distance between the magnetic pole (closer to the center of the operation portion among the two magnetic poles generated by the right and left control portions) and the respective ends of the operation portion (k₁ or k₂ in the drawings) is not more than 0.3L (i.e., not more than 30% of the length L of the operation portion) and the distance between the center of the operation portion and the control portion (S₁ or S₂ in the drawings) is longer than 0.2L (i.e., 20% of the length L of the operation portion). A magnetic element having such an arrangement can undergo a steep discontinuous magnetization reversal even if the length L of the operation portion is short.

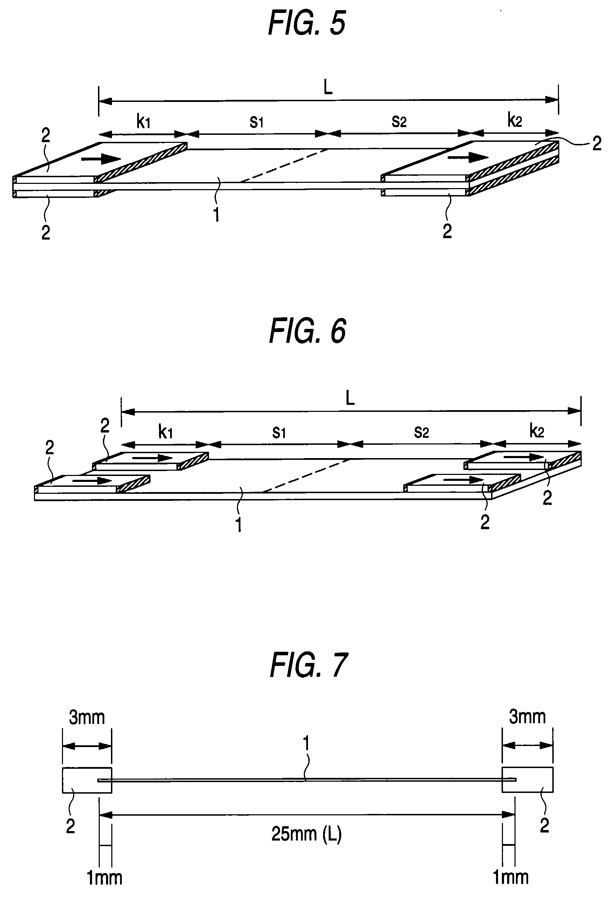

Figs. 5 and 6 each illustrate an embodiment of the magnetic element having two pairs of control portions disposed in the vicinity of the respective ends of the operation portion. Fig. 5 illustrates the case where one pair of control portions is disposed on the upper side of the operation portion and the other is disposed on the lower side of the operation portion. Fig. 6 illustrates the case where the two pairs of control portions are each juxtaposed and disposed on the upper side of the operation portion. In these cases, k₁ and K₂ each are also not more than 0.3L and S₁ and S₂ each are longer than 0.2L. A magnetic element having such an arrangement can undergo a steep discontinuous magnetization reversal even if the length L of the operation portion is short. Furthermore, such magnetic elements readily allow bias magnetic field to be effectively applied to the vicinity of the ends of the operation portion as compared to those having only a pair of control portions disposed thereon.

In order to magnetize each control portion in the magnetic element of the present invention as shown in Figs. 1 to 6 in the same direction, the magnetic element may be passed through a place in which d.c. magnetic field is generated.

The process for magnetizing the magnetic element of the present invention comprising an operation portion and control portions is described below.

When the control portions are demagnetized, the magnetic domains magnetized in positive and negative directions with 180° domain wall interposed therebetween are alternately juxtaposed in the vicinity of the ends of the operation portion. Such a closure domain structure is formed to reduce the external radiation of magnetic flux. The range in which this effect is exerted extends more to the inside (central portion) of the operation portion when the operation portion is smaller and shorter and the resulting demagnetizing field becomes greater. In other words, as the domains tend to he balanced mutually, there is no predominate magnetic domain in a specific direction. Thus, a discontinuous behavior in which magnetization is momentarily inverted at once can hardly occur. When the control portion is then biased with magnetic field, the magnetic domain in the direction of the bias magnetic field grows and predominates at the ends of the operation portion. As a result, when an external magnetic field is applied to the magnetic element in the direction opposite the bias magnetic field, a magnetic element having uniaxial magnetic anisotropy exhibits a steep magnetic reversal at the central portion thereof. It is therefore desirable to prevent the bias magnetic field from exerting an effect on the central part of the operation portion.

In view of the above, the foregoing positional relationship between the operation portion and the control portion is important in the present invention. When a magnetic pole generated by the control portion is not present within a range of not more than 0.3L, (i.e., not more than 30% of the length L of the operation portion) from the respective ends of the operation portion, a discontinuous magnetization reversal is not induced in the operation portion even if the control portions are magnetized in the same direction. Furthermore, when the control portion is present within a range of not more than 0.2L from the center of the operation portion, a bias magnetic field is applied to the center part of the operation portion. Thus, the resulting hysteresis loop is inclined to a greater extent than a magnetic element which does not have a control portion, thus making magnetization reversal difficult.

In the present invention, if a magnetic ink is used as a control portion and it is painted on the entire part of a soft magnetic material, the soft magnetic material can hardly be magnetized than prior to painting the magnetic ink and thus exhibits remarkably deteriorated magnetic characteristics. On the other hand, if the magnetic ink is applied to the soft magnetic material only on the ends thereof, a discontinuous magnetization reversal can be obtained with extremely good reproducibility. In this case, a discontinuous magnetization reversal can be induced in a range much wider than in conventional magnetic elements to provide a steep magnetization reversal under the conditions of the present invention.

The hysteresis loop developed when the control portion of the magnetic element of the present invention is magnetized is essentially asymmetric. When a.c. magnetic field is applied to the magnetic element of the present invention, it undergoes a discontinuous magnetization reversal once per cycle. The hysteresis of the magnetic element of the present invention shifts positive or negative from the origin to undergo a magnetization reversal which reaches 80% to 90% of its saturation magnetization.

### EXAMPLES

The present invention will be further described in the following Examples and comparative Examples. However, the present invention should not be construed as being limited thereto.

### EXAMPLE 1

A magnetic element shown in Fig. 7 was prepared from a fine metallic wire as an operation portion and a metallic ribbon as a control portion. The magnetic characteristics of the magnetic element were measured at 60 Hz using an a.c. B-H tracer (AC, BH-100K, available from Riken Denshi K.K.).

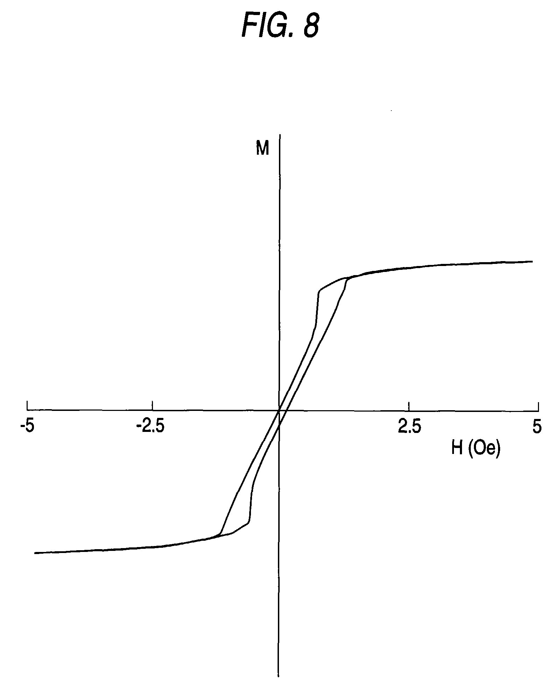

The fine metallic wire of Co₅₉Fe₃₉Si₇B₁₅ (figure indicates atomic percent) having a diameter of 125 µm is produced by melt spining in rotating water method, and it is die-drawn to 110 µm. Then it is annealed at about 400°, and out into 25 mm long piece. Fig. 8 illustrates the magnetic characteristics of this short wire. It could hardly be magnetized due to a strong demagnetizing field. The squareness of the hysteresis loop of the short wire was remarkably deteriorated. Thus,it could only exhibit a continuous magnetization change.

The short fine amorphous metallic wire having remarkably deteriorated characteristics for pulse generator was combined with segments made of a metallic ribbon as a control portion. The segments were obtained by cutting a semi-hard magnetic thin ribbon arnochrome (III) (width: 1.5 mm; thickness: approx, 50 µm, available from Arnold Corp.) into 3-mm piece. Magnetic easy direction of this segment was longitudinal direction, so magnetic pole was generated at both lengthwise ends. This segment also exhibits a coercive force of shout 80 Oe, which is higher than that of the fine metallic wire used as an operation portion. Two sheets of this semi-hard magnetic segment were disposed in the vicinity of the ends of the fine amorphous metallic wire, respectively, in such manner that each segment was superposed on the tip of the fine amorphous metallic wire over a distance of 1 mm and extended in parallel to the lengthwise direction of the fine amorphous metallic wire.

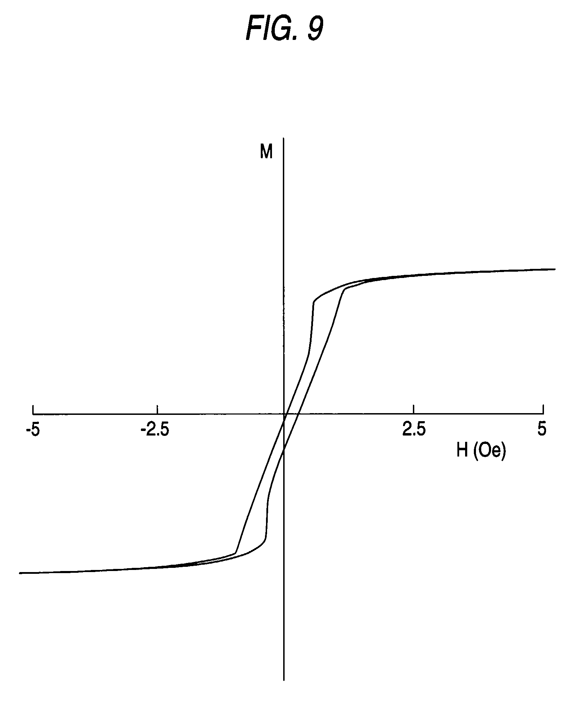

Fig. 9 illustrates the magnetic characteristics of a magnetic element thus prepared when the control portions are demagnetized. The magnetic characteristics were measured in the central portion of the fine amorphous metallic wire. A pickup coil having a width of 10 mm was used so that the magnetization of the semi-hard magnetic segment were not contained in the data. When the control portions are not magnetized, and the operation portion is not biased with local magnetic field, the magnetic element exhibits almost the same magnetic characteristics as shown in Fig. 8 (no control portion), thus exhibits poor characteristics for pulse generator.

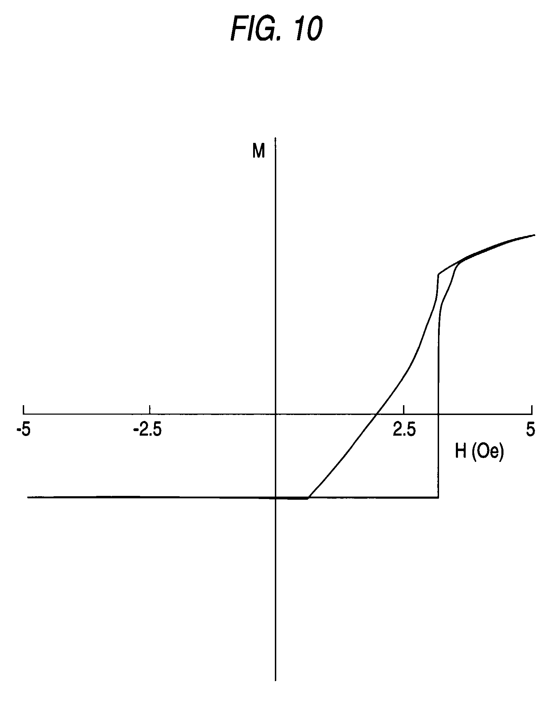

On the other hand, when d.c. magnetic field of 6 kOe was applied to the magnetic element by means of a chemical capacitor type magnetizer SCB-10 (available from Riken Denshi K.K.) parallel to the longitudinal direction of on amorphous wire, the magnetic element exhibited asymmetric hysteresis loop as shown in Fig. 10. Discontinuous magnetization reversal,( i.e., a steep magnetization jump at 2.7 Oe in one cycle) was observed and magnetization attained at this jump was as high as 64% of the saturation magnetization of the fine amorphous metallic wire.

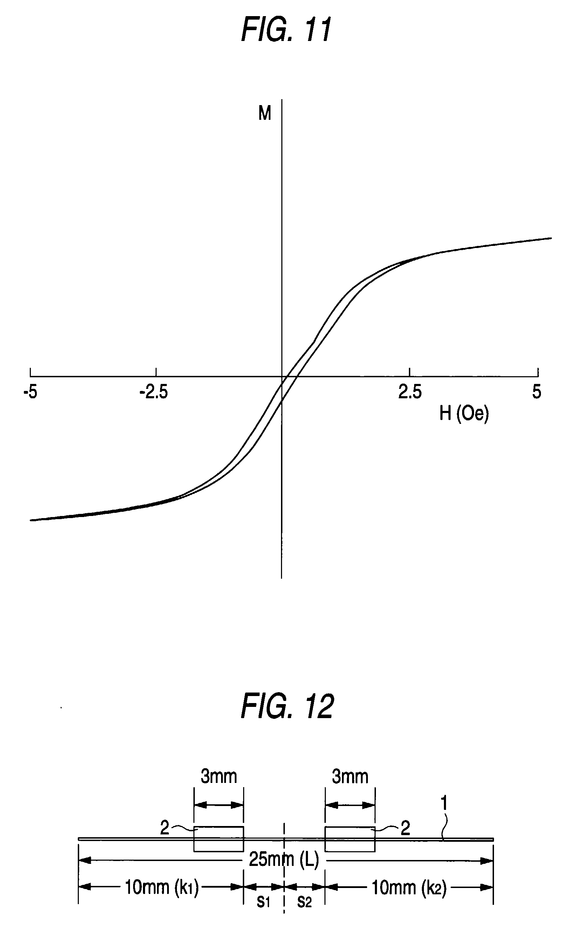

The foregoing characteristics disappear when a gradually decreasing a.c. magnetic field is applied to the magnetic element so that it is demagnetized. Thus, the magnetic element can be reversibly controlled by magnetization and demagnetization. On the other hand, the magnetized semi-hard magnetic segments were removed, and then disposed again on the respective ends of the fine amorphous metallic wire in such manner that the magnetization direction of the two segments were opposite to each other. Fig. 11 illustrates the magnetic characteristics of this arrangement. Fig. 11 shows that even when the control portions are magnetized, the magnetic element does not exhibit a discontinuous magnetization jump and does not exert any effect if the magnetization direction of the two segments are not the same.

It is clearly seen that when a magnetic element having semi-hard magnetic control portions disposed on the respective ends of a soft magnetic operation portion are magnetized in the same direction, the operation portion exhibits excellent pulse-generating characteristics even if it is so small-sized that it is strongly affected by a demagnetizing field.

### COMPARATIVE EXAMPLE 1

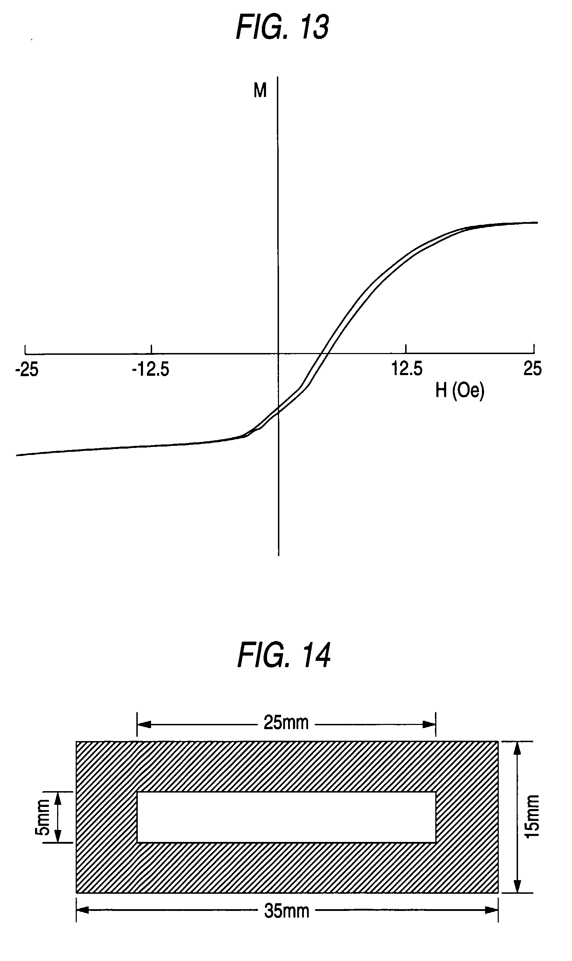

The same fine amorphous metallic wire and semi-hard segment as used in Example 1 were used to prepare a magnetic element having the configuration shown in Fig. 12. The control portions were disposed closer to the center of the operation portion than in Example 1, namely, the distances k₁ and k₂ (between the magnetic poles of the control portions closer to the center of the operation portion and the respective ends of the operation portion) were each 10 mm (40% of the entire length of the operation portion), and the distances S₁ and S₂ (between the magnetic poles and the center of the operation portion) were each 2.5 mm (10% of the entire length of the operation portion). Fig. 13 illustrates the magnetic characteristics of the magnetic element thus prepared when it is magnetized in the same manner as in Example 1. The magnetic element is hardly magnetized and thus exhibits remarkably deteriorated characteristics.

Next, the length of the semi-hard segment and the distance between the semi-hard segment and the end of the wire were varied. As a result, it was found that when the distances k₁ and k₂ (between the magnetic poles and the respective ends of the operation portion) each exceed 7.5 mm (30% of the entire length of the operation portion), the magnetic element does not exhibit a magnetization jump. It was also found that when the control portions generate a magnetic pole within a range of not more than 5 mm (20% of the entire length or the operation portion), the magnetic element exhibits remarkably deteriorated magnetic characteristics.

Furthermore, the length of the fine amorphous metallic wire used as an operation portion was varied for study. As a result, similar results were obtained.

### EXAMPLE 2

A metallic thin film and a magnetic ink were used as an operation portion and a control portion, respectively, to prepare a magnetic element. The magnetic characteristic of the sample thus prepared were then evaluated in the same manner as in Example 1.

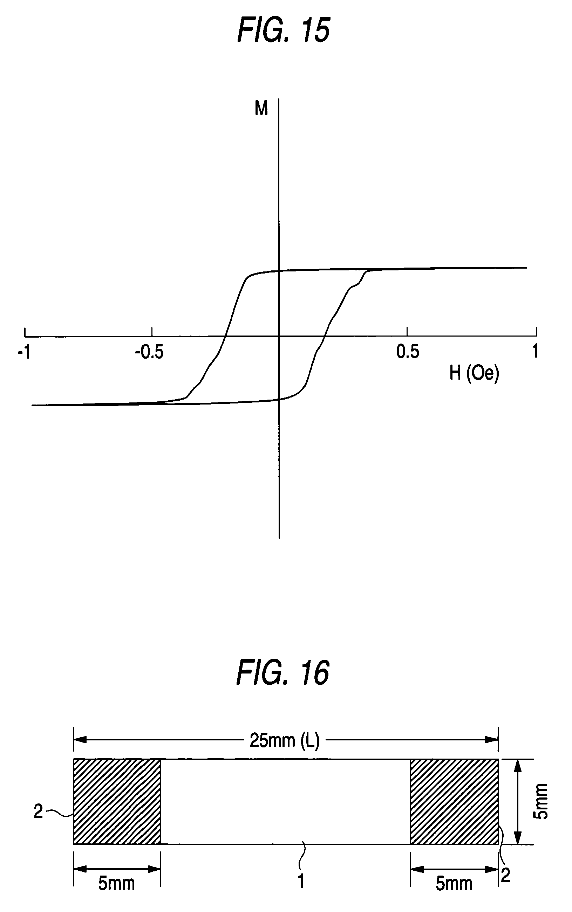

In order to prepare the metallic thin film, Co₅₁Fe₂₆Si₁₀B₁₃ (figure indicates atomic percent) amorphous thin film of 0.5 µm thick was sputtered onto a 125-µm thick polyethylene terephthalate (PET) film substrate with application of d.c. magnetic field by permanent magnets. Prior to forming the thin film, a rectangular frame having a short side of 15 mm and a long side of 25 mm was printed on the PET film with water-soluble ink (available from Osaka Insatsu Ink Seizo K.K.) as shown in Fig. 14. After forming the thin film, the ink was washed away with water to form patterned film having a width of 5 mm, a length of 25 mm and a thickness of 0.5 µm. Fig. 15 illustrates the magnetic characteristics of the metallic thin film fabricated thereof. Since this magnetic element is small and short, the resulting demagnetizing field is strong. Thus, the magnetic element exhibits an inclined magnetic hysteresis loop and thus therefore does not exhibit a steep magnetization change.

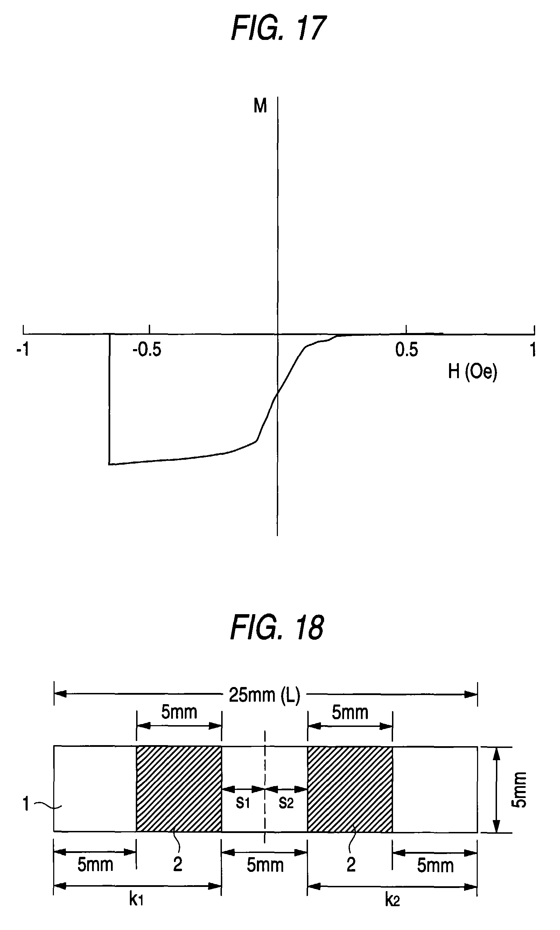

A magnetic ink (available from Toda Kogyo Corp.) was then directly applied to the metallic thin film to form a control portion. The magnetic ink wail applied using a brush in the manner as shown in Fig. 16. The magnetic element having a magnetic ink applied thereto was then magnetized in the same manner as in Example 1. Fig. 17 shows the magnetic characteristics of the magnetic element thus magnetized. Unlike the magnetic element of Fig. 15, the magnetic element of Fig. 17 exhibited a distinct magnetization jump.

### COMPARATIVE EXAMPLE 2

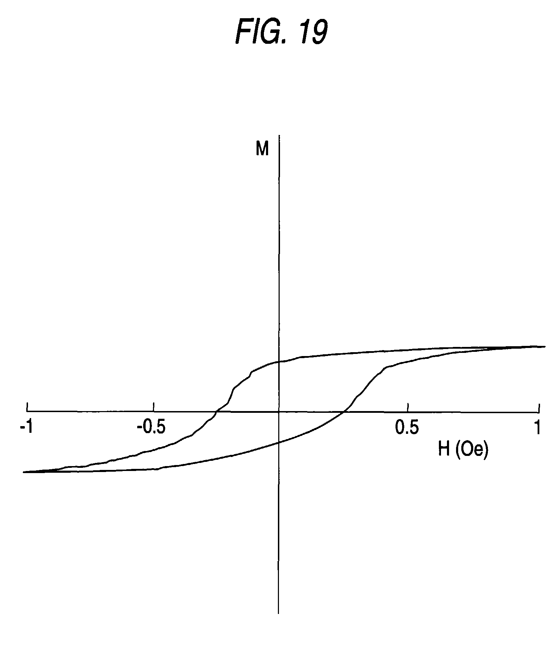

The same thin amorphous film and magnetic ink as used in Example 2 were used to prepare a magnetic element having the arrangement shown in Fig. 18. The control portions were each disposed closer to the center of the operation portion than in Example 2. The magnetic element was also arranged such that the distances k₁ and k₂ (between the magnetic poles of the control portions closer to the center of the operation portion and the respective ends of the operation portion) each were 10 mm (40% of the entire length of the operation portion) and the distances S₁ and S₂ (between the magnetic poles and the cantor of the operation portion) each were 2.5 mm (10% of the entire length of the operation portion). Fig. 19 illustrates the magnetic characteristics of the magnetic element thus prepared when it was magnetized in the same manner as in Example 1. The operation portion was hardly magnetized and thus exhibits remarkably deteriorated characteristics.

The length of the area painted magnetic ink was changed. The distance between the control portion and the end of the thin film which acts as an operation portion was varied. The magnetic characteristic of the magnetic element were measured under these conditions. As a result, it was found that when the distances k₁ and k₂ (between the magnetic pole and the end or the operation portion) each exceed about 7.5 mm (30% of the entire length of the operation portion), the magnetic element does not exhibit a magnetization jump. It was also found that the control portion generates a magnetic pole within a range of not more than about 5 mm (20% of the entire length of the operation portion) from the center of the operation portion, the magnetic element exhibits remarkably deteriorated magnetic characteristics.

Furthermore, the length and width of the thin metal film used as an operation portion were varied for study. As a result, similar results were obtained.

### EXAMPLE 3

The same amorphous thin film as used in Example 2 and an Fe film were used as an operation portion and a control portion, respectively, to prepare a magnetic element. A water-soluble ink (available from Osaka Insatsu Ink Seizo K.K.) was again printed on an amorphous thin film having a composition Co₅₁Fe₂₆Si₁₀B₁₃ (figure indicates atomic percent) which had been patterned to a width of 5 mm, a length of 25 mm and a thickness of 0.5 µm by rinsing in the same manner as in Example 2. An Fe film of 0.1 µm was then sputtered onto it. The ink was then washed away with water and prepared a magnetic element having the arrangement shown in Fig. 16. The Fe film thus formed exhibited a coercive force of about 20 Oe. The ratio of residual magnetic flux density (Bᵣ) to saturated magnetic flux density (Bₛ), (i.e., squareness ratio (Bᵣ/Bₛ)) was almost 1.0.

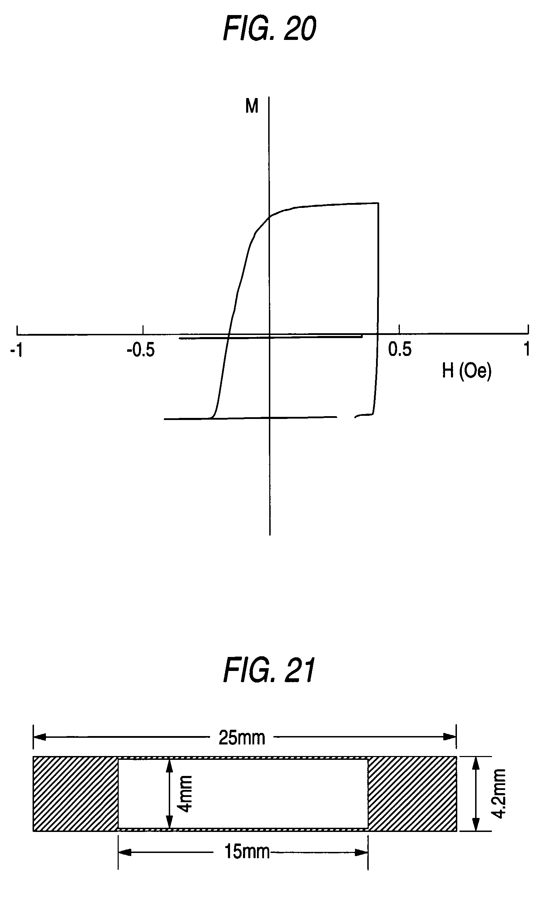

The laminated film thus formed wag magnetized in the same manner as in Example 1, and the magnetic characteristics were then measured. As a result, the magnetic element exhibited a magnetization jump as shown in Fig. 20 and thus provided excellent characteristics for pulse generator.

### EXAMPLE 4

A metallic thin film deposited on surface of PET substrate and deposited on an ink were used as an operation portion and a control portion, respectively, to prepare a magnetic element. The magnetic characteristics of the sample thus prepared were then evaluated in the same manner as in Example 1.

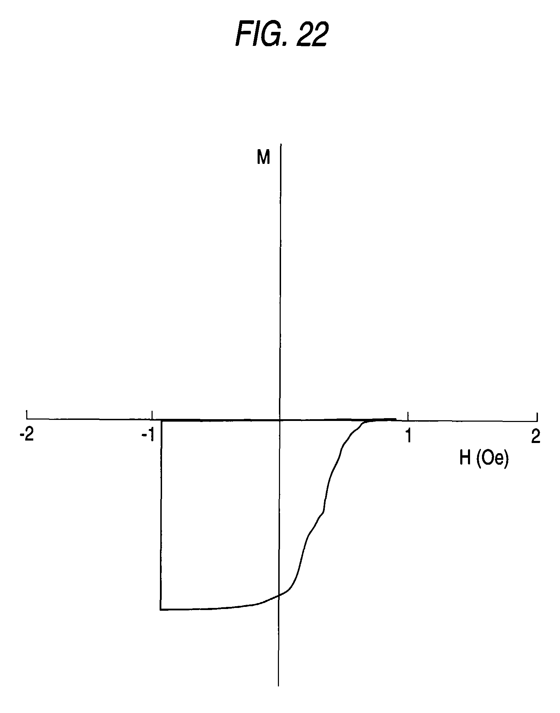

A pattern as shown in Fig. 21 was printed on a 125-µm thick polyethylene terephthalate (PET) film by means of a screen printer (available from Mino Group Co., Ltd.). A water-soluble pigment ink was used (available from Osaka Insatsu Ink Seizo K.K.). The printed film thus obtained was then dried at 150°C in vacuum. A metallic thin film was then formed on it by means of the same apparatus as used in Example 2. The sputtering target was made of pure Fe, and Ar gas containing 15% ethylene gas was used as the sputtering gas. Under these conditions, a thin amorphous FeC thin film having a thickness of about 0.5 µm was formed. The FeC film deposited on the surface of PET film substrate exhibited a coercive force of about 0.3 Oe, while the thin film deposited on the pigment ink exhibited a coercive force as great as about 10 Oe and thus showed hard magnetic characteristics. Since the pigment ink was applied as shown in Fig. 21, the arrangement of the magnetic element was the same as the magnetic element having hard magnetic thin films disposed adjacent to each other on the ends of a soft magnetic thin film. The sample thus prepared was magnetized in the same manner as in Example 1, and the magnetic characteristics were then measured. As a result, the magnetic element exhibited a magnetization jump as shown in Fig. 22 and thus provided excellent characteristics for a pulse generator.

## Claims

1. A magnetic element comprising: an operation portion of length L which undergoes a steep change in magnetization with a change in external magnetic field and at least one pair of control portions having a coercive force that is higher than that of said operation portion, wherein said control portions are disposed in such manner that a magnetic pole of each of said control portions is generated within a range of not more than 0.3L from an end of said operation portion and said control portions are not present within a range of up to 0.2L from the center of said operation portion.

2. The magnetic element as claimed in claim 1, wherein said control portions are magnetized in the same direction so as to bias the operation portion with a static magnetic field.

3. The magnetic element as claimed in claim 1, wherein the operation portion comprises a wire, ribbon and thin film.

4. The magnetic element as claimed in claim 1, wherein the operation portion comprises an amorphous alloy having a composition selected from the group consisting of FeB, FeP, FeC, FeSiB and FeZr.

5. The magnetic element as claimed in claim 1, wherein the operation portion comprises an amorphous alloy having a composition selected from the group consisting of FeB, FeP, FeC, FeSiB and FeZr, and wherein a part of or all of the Fe is replaced by one or both of Co and Ni.

6. The magnetic element as claimed in claim 1, wherein said control portion comprises a segment, thin film or coating.

7. The magnetic element as claimed in claim 1, wherein first and second control portions of said at least one pair of control portions are disposed at opposite ends of the operation portion.

8. The magnetic element as claimed in claim 1, wherein first and second control portions of said at least one pair of control portions are symmetrically disposed about the center of the operation portion.

9. The magnetic element as claimed in claim 1, wherein said control portions are disposed within the respective ends of the operation portion.

10. The magnetic element as claimed in, claim 1, wherein the ends of said control portions coincide with the respective ends of the operation portion.

11. The magnetic element as claimed in claim 10, wherein said control portions protrude from the respective ends of the operation portion.

12. The magnetic element as claimed in claim 1, wherein said control portions are not superposed on the operation portion and are present outside the operation portion.

13. The magnetic element as claimed in claim 7 comprising two pairs of control portions, wherein said first pair is disposed on the upper side of the operation portion ad said second pair is disposed on the lower side of the operation portion.

14. The magnetic element as claimed in claim 7 comprising two pairs of control portions disposed on the upper side of the operation portion, wherein first and second control portions of said first pair are juxtaposed with first and second control portions of said second pair, respectively.

15. The magnetic element as claimed in claim 1, wherein said control portions comprise a magnetic ink.

16. The magnetic element comprising a support having thereon an operation portion of length L which undergoes a steep change in magnetization with a change in external magnetic field end at least first and second control portions having a coercive force that is higher than that of said operation portion, wherein said first control portion is disposed in the vicinity of a first end of the operation portion such that a magnetic pole of said first control portion is generated within a distance of not more than 0.3L from the first end of the operation portion, the second control portion is disposed in the vicinity of a second end of the operation portion such that a magnetic pole of said second control portion is generated within a distance of not more than 0.3L from the second end of said operation portion, and said first and second control portions are not present within a distance of up to 0.2L from the center of said operation portion.

17. The magnetic element as claimed in claim 16, wherein said first and second control portions are symmetrically disposed about the center of the operation portion.

18. The magnetic element as claimed in claim 16, wherein said first and second control portions are magnetized in the same direction so as to bias the operation portion with a static magnetic field.

19. The magnetic element as claimed in claim 16, wherein said first and second control portions are disposed within the respective ends of the operation portion.

20. The magnetic element as claimed in claim 16, wherein the ends of said first and second control portions coincide with the respective ends of the operation portion.

21. The magnetic element as claimed in claim 16, wherein said first and second control portions protrude from the respective ends of the operation portion.

22. The magnetic element as claimed in claim 16, wherein said first and second control portions are not superposed on the operation portion and are present outside the operation portion.

23. The magnetic element as claimed in claim 16, further comprising third and fourth control portions disposed at opposite ends of the operation portion, wherein said first and second control portions are disposed on the upper side of said support and said third and fourth control portions are disposed on the lower side of said support.

24. The magnetic element as claimed in claim 16 further comprising third and fourth control portions disposed at opposite ends of the operation portion, wherein said first and third control portions and said second and fourth control portions are juxtaposed and disposed on the upper side of said support.
